Europäisches Patentamt

European Patent Office

Office européen des brevets

(19)

(11) Veröffentlichungsnummer: **0 021 319**
**A1**

(12) # EUROPÄISCHE PATENTANMELDUNG

(21) Anmeldenummer: 80103365.5

(22) Anmeldetag: 18.06.80

(51) Int. Cl.³: **G 01 R 19/145, H 01 H 51/28**

(30) Priorität: 26.06.79 CH 5933/79

(43) Veröffentlichungstag der Anmeldung: 07.01.81
Patentblatt 81/1

(84) Benannte Vertragsstaaten: **AT BE CH DE FR GB IT LI NL SE**

(71) Anmelder: **Dorn, Josef, Fuchshubelstrasse 13, CH-3063 Ittigen (CH)**

(72) Erfinder: **Dorn, Josef, Fuchshubelstrasse 13, CH-3063 Ittigen (CH)**

(74) Vertreter: **Nithardt, Roland, 41, rue de Neuchâtel, CH - 1400 Yverdon (CH)**

(54) Hochspannungsstromrelais.

(57) Ein in einem Hochspannungsstromkreis zwischen zwei Punkten auftretender Teil- oder Differenzstrom wird mittels Klemmen (11, 12) in eine Wicklung (18) geleitet, zwecks Erzeugung eines gleichgerichteten Magnetfeldes (M). Zwecks Homogenisierung des elektrischen Feldes ist die Wicklung (18) auf einer ringförmigen Hochspannungselektrode (16) angeordnet. In diese ragt zentrisch eine Niederspannungselektrode (32), die in ihrem Innenraum ein durch das Magnetfeld (M) betätigbares Schaltelement (21) aufweist. Bei Verwendung des Relais (10) in einem Wechselstromkreis, ist zwischen den Klemmen (11, 12) und der Wicklung (18) ein Zweiweggleichrichter (17) eingeschaltet, und, sofern das Schaltelement (21) ein Reed-Relais ist, dieses mittels eines Permanentmagneten (28) vorgespannt, um ein Flattern desselben zu verhindern.

## HOCHSPANNUNGSSTROMRELAIS

Die vorliegende Erfindung betrifft ei Hochspannungsstromrelais zum Erfassen eines auf Hochspannungsniveau fliessenden Stromes auf Niederspannungsniveau zwecks automatischer Meldung, so bald der erfasste Strom einen vorbestimmten Wert übersteigt oder unterschreitet.

In Hochspannungsnetzen müssen z,B. Netzteile mit Kondensatorengruppen ausgeschaltet werden, wenn Teilkapazitäten der Kondensatoren, aus welchen Gründen auch immer, defekt werden und dadurch in der oder den Kondensatorengruppen Teil-oder Differenzströme zu fliessen beginnen. Dies um spannungsmässige Ueberbeanspruchungen der verbleibenden intakten Teilkapazitäten zu vermeiden und dadurch deren Zerstörung zu verhindern. Solche Kondensatorengruppen werden in Hochspannungsnetzen speziell in Ankoppelungskreisen zur Uebertragung von Steuersignalen verwendet.

Es ist bekannt, z.B. aus der CH-PS 470 781, zwischen parallelen Serien von Kondensatorengruppen auftretende Differenzströme mittels Elektromagneten und Sättigungsdrosseln zu erfassen und zur Ausschaltung des gefährdeten Anlageteiles zu verwenden. Es ist ferner bekannt, solche Ströme mit Hochspannungswandlern zu erfassen und für Steuer-, Mess-oder Schaltaufgaben heranzuziehen. Es ist auch üblich, Ströme mittels Primärrelais zu erfassen.

Diese bekannten Vorrichtungen weisen aber verschiedene Nachteile auf. Die ersteren insbesondere den, dass sie bewegliche Teile und dem Verschleiss unterworfene Wippen aufweisen, die zweiten den, dass finanzielle Aufwand sehr gross ist und die letzteren liegen mit ihrem Wirkungsbereich um Zehnerpotenzen zu hoch.

0021319

Der vorliegenden Erfindung liegt daher die Aufgabe zugrunde,ein Hochspannungsstromrelais der eingangs erwähnten Art zu schaffen, das im Vergleich zu den bekannten Vorrichtungen zum Erfassen von Teil- und Differenzströmen in Hochspannungsanlagen wesentlich preisgünstiger herstellbar ist und das keinen der erwähnten Nachteile aufweist und wartungsfreundlich ist.

Das erfindungsgemässe Relais soll zudem in der Lage sein, sowohl in Wechsel- als auch in Gleichstromkreisen verwendet werden zu können.

Es soll ferner allen notwendigen Sicherheitsvorschriften entsprechen und einfach herstellbar sein.

Im weiteren soll es auf einfache Art in bestehende Hochspannungsanlagen montierbar sein und über handelsübliche Elemente zur Ausschaltung der gefährdeten Netzteile verwendet werden können.

Erfindungsgemäss wird diese Aufgabe durch ein Hochspannungsstromrelais gemäss dem Oberbegriff des Hauptpatentanspruches gelöst, das dadurch gekennzeichnet ist, dass es in einem Dielektrikum eine ringförmige Hochspannungselektrode aufweist, welche elektrisch mit einem Pol des Hochspannungsstromkreises verbunden ist und elektrisch isoliert eine Wicklung trägt, die ihrerseits elektrisch in den Hochspannungsstromkreis einschaltbar ist, und dass im Wirkungsbereich des durch die Wicklung erzeugbaren Magnetfeldes eine elektrisch leitende Erdelelektrode angeordnet ist, welche in ihrem Innenraum eine durch das Magnetfeld derart beeinflussbare Vorrichtung aufweist, dass diese bei vorbestimmten Magnetfeldstärken ihren elektrischen Schaltzustand ändert oder das Auftreten des vorbestimmten magnetischen Flusses auf elektrische Weise weiterleitet.

Eine vorteilhafte Ausführungsform des erfindungsgemässen Relais ist dadurch gekennzeichnet, dass die Vorrichtung ein Reed-Relais ist.

In einer weiteren vorteilhaften Ausführungsform des erfindungsgemässen Relais wird der Einsatz eines Reed-Relais in einem pulsierenden Magnetfelddadurch ermöglicht, dass dieses mittels eines Permanentmagneten vorgespannt und jenes geglättet wird, wobei unter "geglättet" in diesem

Zusammenhang das Phänomen verstanden wird, dass durch die Ueberlagerung eines pulsierenden Magnetfeldes M durch ein Permanentfeld m der Wert $-\cos x \, \big|_0^\pi$, der die durch das pulsierende Feld M bedeckte Fläche in einem Rechteck von 0 bis $\pi$ definiert, durch das Feld m um den Wert 1 + m erhöht wird, was sich in der Auswirkung auf das pulsierende Magnetfeld wie eine Glättung auswirkt.

Weitere vorteilhafte Ausgestaltungen des erfindungsgemässen Hochspannungsstromrelais gehen aus den Patentansprüchen hervor.

Eine spezifische Ausführungsvariante des erfindungsgemässen Relais ist in der folgenden Beschreibung anhand der Zeichnung erläutert. In dieser zeigt :

Fig. 1 ein Hochspannungsnetzteil, in welchem drei erfindungsgemässe Hochspannungsstromrelais Verwendung finden und

Fig. 2 eines der in Fig. 1 schematisch angedeuteten erfindungsgemässen Relais im Detail.

Dazu ist zu vermerken, dass es sich bei der gezeigten und beschriebenen Ausführungsvariante der Erfindung um ein Hochspannungsstromrelais für den Einsatz in einem Wechselstromkreis handelt. An anderer Stelle wird darauf hingewiesen werden, inwiefern sich diese Ausführungsvariante von einer solchen für den Einsatz in einem Gleichstromkreis unterscheidet.

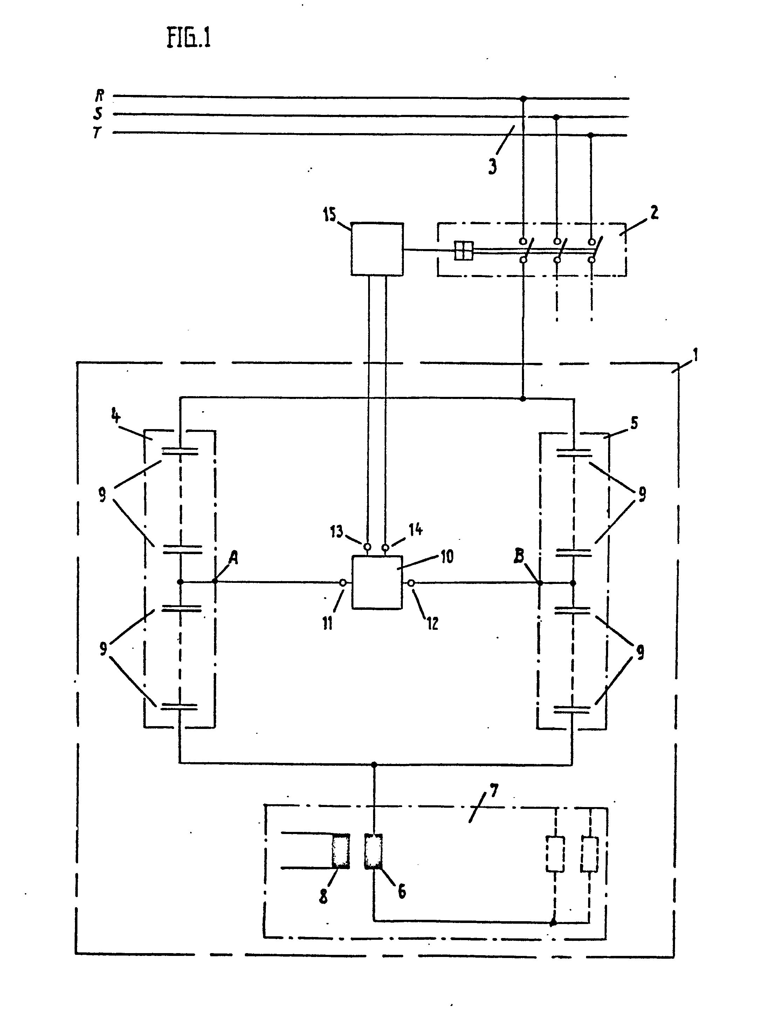

Fig. 1 stellt einen Teil einer Ankopplung 1 für Tonfrequenzen in einer Hochspannungsanlage dar, welche über den Hochspannungsschalter 2 mit dem Hochspannungsnetz 3 verbunden ist. Die parallelen Hochspannungskondensatoren 4 und 5 sind in Serie mit der Spule 6 des Kopplungstransformators 7 geschaltet und bilden dadurch mit diesem einen Schwingkreis, welcher durch die Spule 8 angesteuert werden kann.

Die Kondensatoren 4 und 5 enthalten in ihrem Inneren eine geradzahlige Mengen in Serie geschalteter Teilkapazitäten 9. Die Verbindung der Teilkapazitäten (n:2) und (n:2)+1 ist auf das jeweilige Eisenblechgehäuse A respektive B der isoliert aufgestellten Kondensatoren geführt.

Sind die beiden Kondensatorgehäuse A und B miteinander verbunden, so fliesst über diese Verbindung ein Differenzstrom, so bald eine der Teilkapazitäten 9 einen Durchschlag oder einen anderen Defekt aufweist. Diesen Differenzstrom kann das erfindungsgemässe Hochspannungsstromrelais 10 erfassen, wenn es mit seinen Anschlüssen 11 und 12 in die Verbindung der beiden Kondensatorgehäuse A und B geschaltet wird, wodurch es, über seine Klemmen 13 und 14 mit der Schaltersteuerung 15 verbunden, in der Lage ist, den Hochspannungsschalter 2 auszulösen. Dadurch kann die Ankopplung 1 in einem Zeitpunkt vom Hochspannungsnetz 3 getrennt werden, in welchem noch keinerlei Gefahr einer Zerstörung der Kondensatoren besteht.

Es ist selbstverständlich, dass jede der drei Phasen R, S, T des Hochspannungsnetzes 3 mit einer identisch aufgebauten Ankopplung 1 verbunden sein kann, wobei deren Funktion absolut mit der hier im Zusammenhang mit der Phase R illustrierten übereinstimmt.

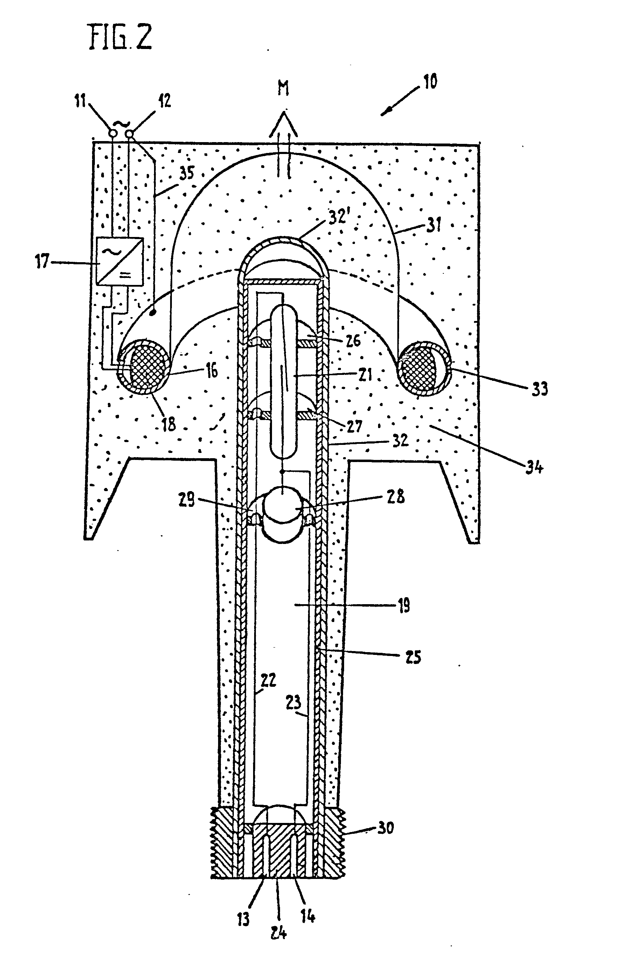

In Fig. 2 erkennt man ein aufgeschnittenes Hochspannungsstromrelais 10, das mittels seinen zwei Klemmen 11 und 12 in die auf Teil- oder Differenzströme hin zu überwachende Hochspannungs-Ankoppelungsanlage, hier ein Wechselstromkreis anschliessbar ist. Eine der Klemmen 11 und 12, hier die Klemme 12, ist über eine elektrische Verbindung 15 mit der elektrisch leitenden, ringförmigen Hochspannungselektrode 16 verbunden. Gleichzeitig sind beide Klemmen 11 und 12 über einen Gleichrichter 17, bei welchem es sich vorteilhafterweise um eine Graetzschaltung handelt, mit einer Wicklung 18 verbunden, die auf der als Spulenkörper dienenden Hochspannungselektrode 16 aufgewickelt ist. Zentrisch in die Hochspannungselektrode 16 ragt eine aus einem metallenen NE-Rohr gebildete Erdelektrode 32, die eine elektrisch isolierte, durch ein Magnetfeld betätigbare Vorrichtung 21 trägt. Vorteilhafterweise handelt es sich dabei um ein Reed-Relais, das über zwei Leitungen 22 und 23, die in einen Stecker 24 münden, der die Anschlüsse 13 und 14 trägt, mit diesen verbunden ist.

Mit der Hochspannungselektrode 16 elektrisch verbunden ist eine topfförmige Abschirmung 24, vorzugsweise aus einer Graphitschicht oder Metallgaze, die dazu dient, ein weitgehend homogenes elektrisches Feld zu erhalten, um einen Durchschlag zwischen den auf Hochspannungsniveau befindlichen Elementen 17, 15, 11 und 12 und der Erdelektrode 32 auszuschliessen. Um das Reed-Relais 21 richtig positionieren und in der Hülse 25 auch festhalten zu können, kann dieses mittels zwei Positionierungsringen 26 und 27 in letztere eingepasst werden. Ferner kann in die Hülse 25 ein Permanentmagnet 28, ebenfalls in einem Positionierungsring 29 gehalten, eingefügt werden, dessen Zweck es ist, das Reed-Relais 21 magnetisch vorzuspannen.

Zwecks Montage des Hochspannungsstromrelais 10, z.B. auf einen hier nicht dargestellten Kondensatorträgerrahmen, kann die Erdelektrode 32 an ihrem unteren Ende mit einem Gewinde 30 oder einem Flansch versehen sein, an welchem auch die Erdung vorzunehmen ist. Um zwischen der Erdelektrode 32 und der Abschirmung 31 hohe elektrische Feldstärken zu vermeiden, ist es vorteilhaft, das obere Ende 33 der Erdelektrode 32 halbkugel- oder kugelförmig zu gestalten.

Für sehr hohe Spannungen ist es angebracht, zwischen den Erd- und Hochspannungselektroden Steuerelektroden einzufügen, wie es z.B. bei Hochspannungskondensatordurchführungen üblich ist.

Um die einzelnen Elemente des erfindungsgemässen Hochspannungsstromrelais 10 vor äusseren Einflüssen zu schützen und elektrisch bestmöglich voneinander zu isolieren, sind diese in ein Dielektrikum 34 eingegossen oder in Oelpapierisolation in einem Porzellanisolator untergebracht, deren Formgebung und Dimensionierung gemäss den bekannten Normen der Hochspannungstechnik zu erfolgen hat und auf die hier nicht näher eingegangen wird.

Die Funktionsweise des erfindungsgemässen Hochspannungsstromrelais ist folgende : sofern zwischen den Klemmen 11 und 12 ein Differenzstrom fliesst, wird durch die unter gleichgerichtetem Hochspannungsstrom stehende Wicklung 18 ein gleichgerichtetes, pulsierendes Magentfeld erzeugt, das bei entsprechender Wickelrichtung und Polarität des Stromes, z.B. gemäss des Pfeiles M gerichtet sein kann und auch den von der Erdelektrode 16 eingeschlossenen Raum durchsetzt. Die Stärke des Magnetfeldes M ist dabei von der Stärke des zwischen den Klemmen 11 und 12 fliessenden Stromes abhängig. Zwecks Glättung des pulsierenden Magnetfeldes M, ohne Verwendung von Glättungskondensatoren im Anschluss an den Zwei- weggleichrichter 12, ist die Hochspannungselektrode 16 als Kurzschlusswindung, z.B. aus einem Kupferrohrring mit einer an seiner Aussenseite
angeordneten Nut 33, zwecks Einbringung der Wicklung 18, auszuführen.
Wird das durch die Spule erzeugte magnetische Feld über das Transformatorprinzip erfasst, so entfällt sowohl die oben erwähnte Gleichrichtung
des Stromes, als auch die Ausführung der Elektroden als Kurzschlusswindung. Bei Einsatz des erfindungsgemässen Hochspannungsstromrelais in
einem Gleichstromnetz kann die Hochspannungselektrode 16 aus einem beliebigen anderen elektrisch leitenden Ring bestehen, da in diesem Fall
das Magnetfeld nicht geglättet werden muss. Die Verwendung eines elektrisch leitenden Materials für die ringförmige Hochspannungselektrode
16 oder zumindest deren Oberfläche und die rohrförmige Endelektrode 32
ist in jedem Falle notwendig, um eine Homogenisierung des zwischen den
Elektroden (19, 32) auftretenden elektrischen Feldes zu erwirken.

Um sicherzustellen, dass das Reed-Relais 21 selbst im Falle des trotz
Glättung noch leicht pulsierenden Magnetfeldes sauber und sicher genau
dann schaltet, wenn der zwischen den Klemmen 11 und 12 als maximal zulässig erachtete Differenzstrom überschritten wird, ist dieses, bei Verwendung des erfindungsgemässen Hochspannungsstromrelais für Wechselstrom, mittels eines Permanentmagneten 28, dessen Feld ebenfalls die
Richtung des Pfeiles M hat, vorzuspannen. Durch Verschiebung des Permanentmagneten 28 kann das Reed-Relais 21 magnetisch so vorgespannt werden, dass es sich erst dann schliesst, wenn sich der infolge der Toleranzen der Kondensatoren 4 und 5 fliessende Differenzstrom aufgrund eines Defektes einer Teilkapazität 9 in unzulässiger Weise erhöht. Zudem
kann mit dem Permanentmagneten 28 verhindert werden, dass das Reed-Relais 21 beim Schliessen oder Oeffnen im Rhythmus des pulsierenden Magnetfeldes der Spule 18 flattert.

Da Reed-Relais bekanntlich sehr schnelle Schalter sind und da durch die
Uebertragung von Signalen höherer Frequenz als der Netzfrequenz wegen
der Fertigungstoleranz der Kondensatoren 4 und 5 zwangsläufig zwischen
diesen über das Hochspannungsstromrelais 10 ein Differenzstrom fliesst,
der zu kurzfristigem Schliessen des Reed-Relais 21 im Rhythmus der übermittelten Frequenzen führen kann, was aber nicht zur Abschaltung vom
Netz 3 führen darf, wird in der herkömmlichen Schaltersteuerung 15 mit
Zeitglied dafür gesorgt, dass während der Sendung von Signalimpulsen die Hochspannungsschalter-Auslösung unterbunden wird.

Der Fachmann erkennt, dass das erfindungsgemässe Hochspannungsstromrelais auch für andere als die hier beschriebene Anwendung verwendet werden kann. Er erkennt ferner, dass das erfindungsgemässe Relais sehr wartungsfreundlich ist, da dank der Tatsache, dass die das Reed-Relais 21 aufnehmende Hülse 25 problemlos ausgewechselt werden kann, der einzige Teil des Hochspannungsstromrelais, der einer Alterung unterworfen ist. Durch den sehr einfachen Aufbau des genannten Relais kann dieses auch preisgünstig gefertigt werden.

Der Fachmann erkennt ferner, dass das erfindungsgemässe Hochspannungsstromrelais in einzelnen Punkten anders aufgebaut werden kann, als dies beim beschriebenen Ausführungsbeispiel der Fall ist. Beispielsweise ist es möglich, das Reed-Relais 21 und, sofern vorhanden, den Permanentmagneten 28 in der Erdelektrode 32 anders zu befestigen, z.B. durch Vergiessen der Hülse 25. Ferner kann die Erdelektrode 32 in ihrem unteren Teil anders gestaltet werden, je nach dem, wo und wie das Hochspannungsstromrelais montiert werden soll. Ferner ist es möglich, als Schaltelement 21 anstelle eines Reed-Relais andere Elemente zu verwenden, die mittels eines Magnetfeldes beeinflussbar sind, z.B. einen Hallgenerator, einen magnetisch sensiblen Halbleiter, eine Spule als Sekundärwocklung eines Transformators oder andere. Als Erdelektrode 32 eignet sich z.B. ein Messingrohr und als Hochspannungselektrode 16 ein Kupferrohr, so lange es sich um einen Gleich- oder gleichgerichteten Strom handelt, welcher die Spule durchfliesst. Wird die Spule von Wechselstrom durchflossen, so ist darauf zu achten, dass die Elektroden keine Kurzschlusswindungen darstellen. Als Abschirmung 31 kann eine dünne Graphitschicht in Form eines Topfes oder ein metallischer Topf so angebracht werden, dass sie fest und leitend mit der Hochspannungselektrode verbunden ist. Bei den anderen Teilen, wie z.B. dem Zweiweggleichrichter 17, dem Reed-Relais 21, dem Permanentmagneten 28 und dem Stecker 24 kann es sich um handelsübliche Komponenten handeln, die nach den allgemein bekannten Kriterien ausgewählt werden. Dies gilt ebenso für die Wicklung 18, die ja nach Spannung und maximal zu erwartendem Differenzstrom und Stärke des zu erzeugenden Magnetfeldes M, dimensioniert wird. Die Hülse 25 kann aus einem Hartpapier- oder einem Kunststoffrohr bestehen und in beliebiger Art, z.B. mittels eines Gewindes, eines Anschlages, etc. in der Erdelektrode 32 positioniert und befestigt werden.

Patentansprüche

1. Hochspannungsstromrelais zum Erfassen eines auf Hochspannungsniveau fliessenden Stromes auf Niederspannungsniveau, so bald der erfasste Strom einen vorbestimmten Wert übersteigt oder unterschreitet, dadurch gekennzeichnet, dass es in einem Dielektrikum (34) eine ringförmige Hochspannungselektrode (16) aufweist, welche elektrisch mit einem Pol des Hochspannungsstromkreises verbunden ist und elektrisch isoliert eine Wicklung (18) trägt, die ihrerseits elektrisch in einen Hochspannungsstromkreis einfügbar ist, und dass im Wirkungsbereich des durch die Wicklung (18) fliessenden Stromes erzeugbaren Magnetfeldes (M) eine elektrisch leitende Erdelektrode und eine durch das Magnetfeld derart beeinflussbare Vorrichtung (21) angeordnet sind, dass sie bei vorbestimmten Magnetfeldstärken ihren elektrischen Schaltzustand ändert.

2. Relais nach Anspruch 1, dadurch gekennzeichnet, dass sich die Vorrichtung (21) im Innenraum (19) der Erdelektrode (32) befindet.

3. Relais nach Anspruch 1, dadurch gekennzeichnet, dass die Hochspannungselektrode (16) elektrisch mit einer topfförmigen elektrischen Abschirmung (31) verbunden ist, die das in die Hochspannungselektrode (16) hineinragende Ende (35) der Erdelektrode (32) elektrisch abschirmt.

4. Relais nach Anspruch 1, dadurch gekennzeichnet, dass die Vorrichtung (21) ein Reed-Relais, eine Spule mit oder ohne Kern, ein Hallgenerator oder ein magnetisch sensibler Halbleiter ist.

5. Relais nach Anspruch 1, dadurch gekennzeichnet, dass die Hochspannungselektrode (16) ein aussen geschlitzter Nichteisen-Metallrohrring ist.

6. Relais nach den Ansprüchen 1 bis 5 für den Einsatz in einem Wechselstromkreis, dadurch gekennzeichnet, dass der Wicklung (18) ein Zweiweggleichrichter (17) vorgeschalten ist und in der Erdelektrode (32) ein Permanentmagnet (28) zwecks Vorspannung des Reed-Relais (21) und Ueberlagerung des durch den elektrisch nicht geglätteten Strom in der

0021319

Wicklung (18) erzeugten pulsierenden magnetischen Feldes angeordnet ist.

7. Relais nach Anspruch 1, dadurch gekennzeichnet, dass die Abschirmung (29) aus einer Graphitschicht besteht.

0021319

**FIG.1**

0021319

FIG.2

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | <u>FR - A - 2 204 808</u> (COMMISSARIAT A L'ENERGIE ATOMIQUE)<br><br>* Seite 3 - Seite 8 *<br><br>-- | 1,3,4 |
| | <u>US - A - 3 365 665</u> (HOOD)<br><br>* Spalte 2, Zeile 44 - Spalte 3, Zeile 5 *<br><br>-- | 4 |
| | <u>US - A - 3 708 724</u> (E.O. SCHNEIZER)<br><br>* Spalte 1, Zeile 37 - Spalte 4, Zeile 67 *<br><br>---- | 6 |

**KLASSIFIKATION DER ANMELDUNG** (Int. Cl.³)

G 01 R 19/145
H 01 H 51/28

**RECHERCHIERTE SACHGEBIETE** (Int. Cl.³)

G 01 R 19/145
19/165
H 02 H 1/00
51/28
G 01 R 15/02

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent-familie, übereinstimmendes Dokument

Der vorliegende Recherchenbericht wurde für alle Patentansprüche erstellt.

| Recherchenort Den Haag | Abschlußdatum der Recherche 18-09-1980 | Prüfer BERTIN |
|---|---|---|

EPA form 1503.1 06.78